# EUROPEAN PATENT APPLICATION

(11) **EP 4 815 670 A1**
(43) Date of publication of application: **30.09.2026**
(21) Application number: 26163878.7
(22) Date of filing: 11.03.2026
(51) Int. Cl.: H10D 64/01, H10D 62/832, H10D 62/40, H10P 34/42, H10P 90/00, H10D 8/60, H10D 62/10

(54) **METHOD OF STRESS RELEASE IN POLYCRYSTALLINE SILICON CARBIDE DEVICES**

(30) Priority: 25.03.2025 IT 202500006135
(71) Applicant: STMicroelectronics International N.V., 1228 Plan-les-Ouates, Geneva (CH)
(72) Inventor: RASCUNA', Simone, 20864 AGRATE BRIANZA (MB) (IT); BADALA', Paolo, 20864 AGRATE BRIANZA (MB) (IT); BELLOCCHI, Gabriele, 20864 AGRATE BRIANZA (MB) (IT); BASSI, Anna, 20864 AGRATE BRIANZA (MB) (IT); LANDI, Antonio, 20864 AGRATE BRIANZA (MB) (IT); BOSCAGLIA, Massimo, 20864 AGRATE BRIANZA (MB) (IT)
(74) Representative: Studio Torta S.p.A.

(57) **Abstract**

Method of manufacturing an electronic device, comprising: providing a substrate (2) of polycrystalline silicon carbide, having a first surface (2a) and a second surface (2b') opposite to the first surface along a first direction (Z); depositing, on the second surface, a first metal layer (10) having a third surface (10a) opposite to the second surface along the first direction; heating, by means of a first laser beam, a first set of portions among a plurality of portions (104) of the third surface; wherein the portions of the plurality of portions extend along a plurality of rows substantially parallel to each other along a second direction (X); and wherein the portions of the plurality of portions extend along a plurality of columns substantially parallel to each other along a third direction (Y).

## Description

### TECHNICAL FIELD

The present invention relates to a method of manufacturing an electronic device, and to the electronic device thus manufactured. In particular, the invention applies to polycrystalline silicon carbide electronic devices.

### STATE OF THE ART

Thinning of silicon carbide (SiC) wafers, used as substrates on which power electronic devices are manufactured, is essential for providing next-generation devices. In fact, by reducing the thickness of the silicon carbide wafers, in particular of the polycrystalline silicon carbide (Poly-SiC) wafers, the power dissipation of such electronic devices may be significantly reduced.

Poly-SiC wafers used as substrates on which power electronic devices are manufactured are generally doped, and have a resistivity comprised, for example, between 0.1 mΩ·cm and 10 mΩ·cm.

During a manufacturing process, a Poly-SiC wafer comprising on one first side thereof one or more electronic devices (e.g. diodes or transistors) is thinned, through a per-se-known process of thickness rectification or reduction, known as a "grinding" process, carried out on a second side of the Poly-SiC wafer opposite to the first side.

Following the grinding process, a metal contact is formed on the second side of the Poly-SiC wafer, for example made of nickel (Ni) or titanium (Ti). Typically, this metal contact has a thickness equal to or greater than 50 nm.

Following the formation of the metal contact, an ohmic contact between the metal contact and the second side of the Poly-SiC wafer, is formed.

However, following the grinding process, the mechanical integrity of the Poly-SiC wafer is significantly compromised. In fact, following this process, the Poly-SiC wafer undergoes deformations such as bow and warpage. These deformations remain even following the formation of the metal contact.

Under certain conditions, these deformations may critically hinder subsequent processing steps, leading to complications such as for example increased difficulty in handling the Poly-SiC wafer, a risk of breakdown of the Poly-SiC wafer, a decrease in the yield of the manufacturing process, and possible damage to the machinery used in the manufacturing process.

Furthermore, the demand for increasingly thinner Poly-SiC wafers (e.g. Poly-SiC wafers with thicknesses comprised between 70 µm and 200 µm) and with increasingly larger diameters, for example with diameters of 300 mm or more, exacerbates these issues.

CN 119 400 756 discloses a general method of manufacturing a power device on a polycrystalline SiC substrate. A metal layer is deposited and subjected to laser annealing to form a backside ohmic contact.

US 2017/033010 A1 relates to a power SiC device formed on a polycrystalline SiC substrate. The method includes using laser annealing to form the backside metallization, but does not disclose a specific pattern.

US 2019/371893 A1 discloses forming a polycrystalline SiC substrate by partially converting a monocrystalline SiC substrate. A metal layer deposited thereon is then locally heated with a laser to form an ohmic contact.

US 2005/104072 A1 discloses a method for locally annealing a metal layer on a crystalline SiC substrate. A laser is used to apply heat in a specific matrix pattern in the X and Y directions through a mask.

US 2023/317666 A1 describes applying laser energy in a matrix pattern using multiple, different laser shots. This creates regions with varying exposure levels on the backside of a substrate for contact formation.

EP 4 113 581 A1 discloses laser annealing of a backside metal layer using a matrix pattern. It further discloses specific laser parameters, including wavelength, pulse duration, and energy density for the process.

However, the above-mentioned issues are not solved.

A need is therefore felt to provide a method of manufacturing polycrystalline silicon carbide wafers, such as to overcome the drawbacks of the prior art.

### SUMMARY

The present invention relates to a method of manufacturing an electronic device and to the electronic device thereof, as defined in the attached claims.

### BRIEF DESCRIPTION OF THE DRAWINGS

For a better understanding of the present invention, some embodiments thereof are now described, purely by way of non-limiting example, with reference to the attached drawings, wherein:
- Figures 1-5 illustrate, in a lateral sectional view, steps of a manufacturing process of a polycrystalline silicon carbide wafer;
- Figure 6 illustrates, in a lateral sectional view, an electronic device accommodated on the polycrystalline silicon carbide wafer manufactured by the manufacturing process of Figures 1-5; and
- Figures 7A-7H illustrate, in plan view, distribution patterns of energy density supplied by a laser on a back face of the polycrystalline silicon carbide wafer of Figures 1-5.

### DESCRIPTION OF EMBODIMENTS OF THE INVENTION

According to one aspect of the present invention, a manufacturing process of a polycrystalline silicon carbide (Poly-SiC) wafer is described.

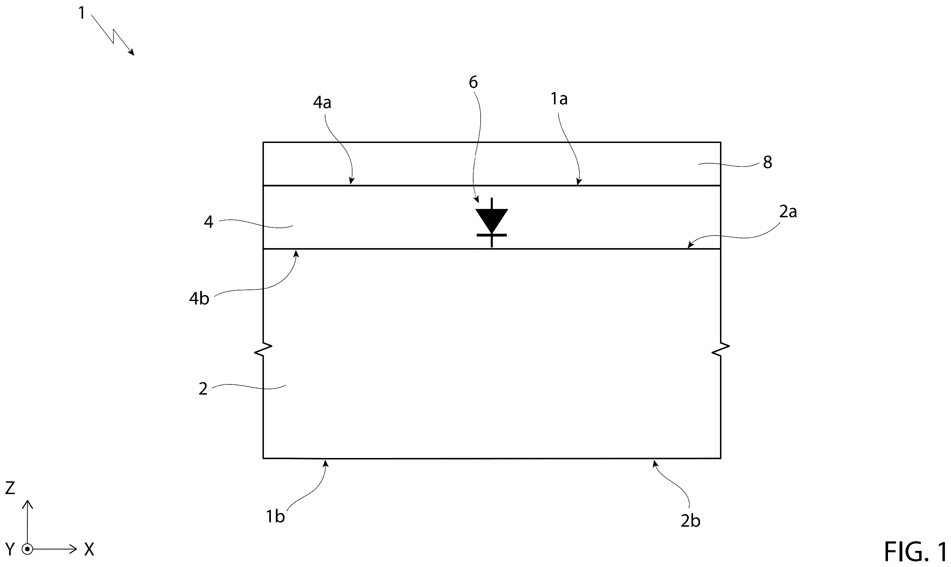

Figures 1-5 illustrate steps of a manufacturing process of a wafer 1 of polycrystalline silicon carbide. Figures 1-5 are represented in a triaxial system of axes X, Y, Z orthogonal to each other, in lateral section on the XZ plane.

With reference to Figure 1, the wafer 1 includes a substrate 2, having an upper surface 2a on which one or more layers 4 extend, which hereinafter will be referred to as the "layer stack" 4.

In detail, the layer stack 4 has a lower surface 4b extending in contact with the upper surface 2a of the substrate 2 and an upper surface 4a thereof opposite to the lower surface 4b along the Z-axis. The upper surface 4a of the layer stack 4 forms a front face 1a of the wafer 1. The substrate 2 has a lower surface 2b opposite to the upper surface 2a along the Z-axis, and forming a back face 1b of the wafer 1.

The substrate 2 is of polycrystalline silicon carbide, and has a first electrical conductivity, for example of the N-type, and a resistivity comprised, for example, between 0.1 mΩ·cm and 10 mΩ·cm.

The substrate 2 has a thickness along the Z-axis comprised between 300 µm and 550 µm, in particular equal to 500 µm in case the wafer 1 has a diameter of 200 mm in the XY plane, and equal to 350 µm in case the wafer 1 has a diameter of 150 mm in the XY plane.

In an illustrative and non-limiting manner, the wafer 1 also includes at least one electronic device 6 of a type known per se, for example a diode, illustrated only schematically in Figures 1-5, formed at least in part in the layer stack 4. In particular, the layer stack 4 includes a plurality of layers of a respective semiconductor, conductor or dielectric/insulating material.

With reference to Figure 1, according to a step of the method described herein, a protective layer 8, for example an adhesive tape, is applied on the front face 1a of the wafer 1 to protect the electronic device 6 and support the wafer 1 during subsequent processing steps of the wafer 1.

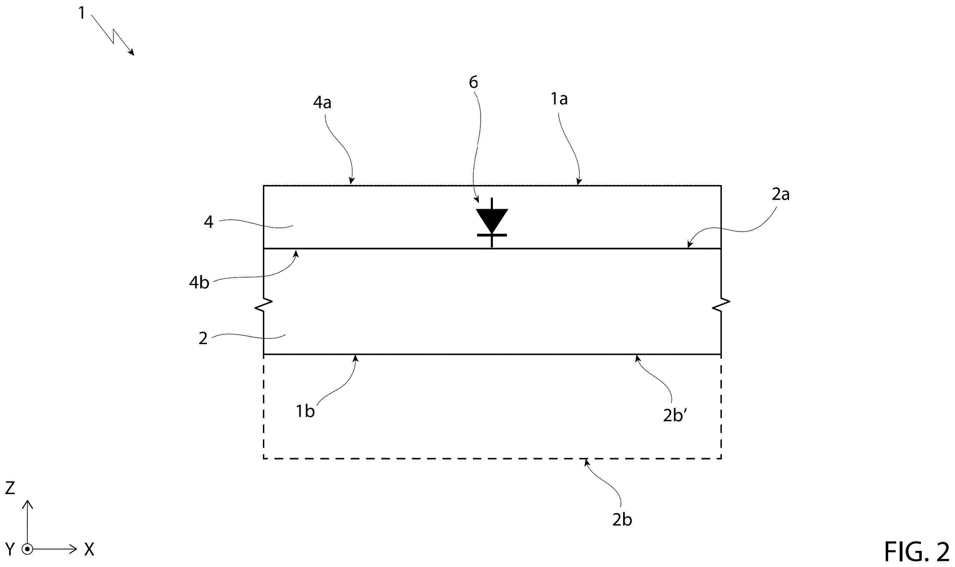

With reference to Figure 2, a grinding step is performed on the back face 1b of the wafer 1, to reduce the thickness of the wafer 1, in particular by thinning the substrate 2. The grinding step includes for example, in a manner known per se, a mechanical / chemical thinning step (e.g., including CMP - "Chemical Mechanical Polishing") of the substrate 2, removing material from the lower surface 2b of the substrate 2.

In detail, the thickness of the substrate 2 is reduced to a final thickness, along the Z-axis, comprised between 70 µm and 200 µm, for example equal to 180 µm. The substrate 2 thus exposes a new lower surface 2b', defining the back face 1b of the wafer 1.

The protective layer 8 is then removed.

At the end of the grinding step, the wafer 1 is typically deformed (not planar), with a deformation that may be asymmetric (in plan view, the deformation of the wafer 1 along directions orthogonal to each other, X-Y, is not symmetric).

The deformation of the wafer 1 is caused by mechanical stress accumulated during the grinding step and due to the introduction of defects in the polycrystalline structure of the Poly-SiC of the substrate 2, in particular in proximity to the lower surface 2b' of the substrate 2. In particular, due to the polycrystalline structure of the Poly-SiC of the substrate 2, the wafer 1 is, following the grinding process, subject to greater deformations than monocrystalline silicon carbide wafers. In particular, the grinding process introduces damage to the surface and to a layer underlying the surface, observable by AFM ("Atomic Force Microscopy") analysis and TEM ("Transmission Electron Microscopy") analysis in section, as shown in P. Badalà, et. al. "Electrical and structural properties of ohmic contacts of SiC diodes fabricated on thin wafers", Solid State Phenomena, 359 (2024) 97-103.

For example, in case the wafer 1 has a diameter of 300 mm in the XY plane, the wafer 1 may have a deviation from planarity, along the X-axis, for example equal to 2.0 mm, and a deviation from planarity, along the Y-axis, for example equal to 0.1 mm.

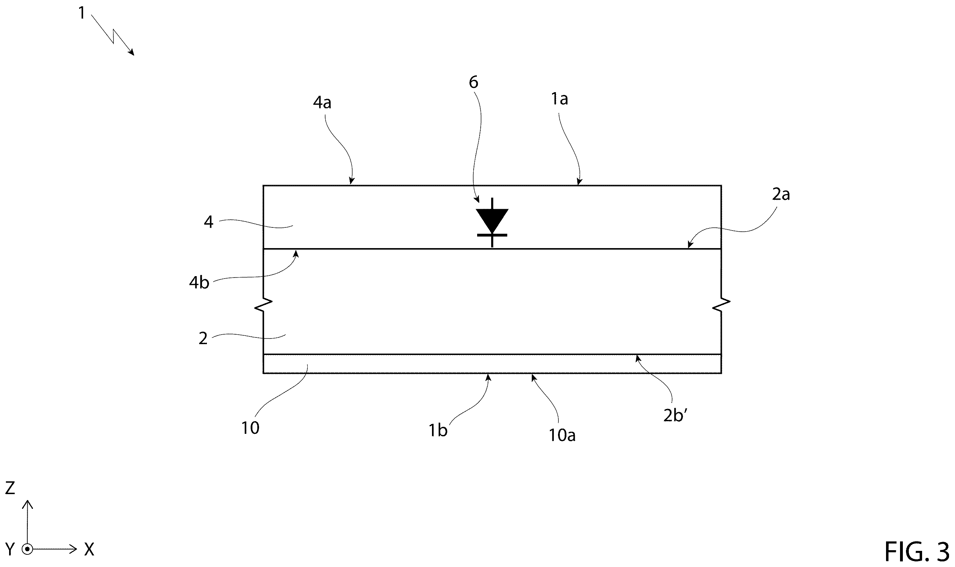

With reference to Figure 3, a deposition step of a first metal layer 10 is carried out on the back face 1b of the wafer 1. In particular, the first metal layer 10 extends in direct physical contact with the lower surface 2b' of the substrate 2.

The first metal layer 10 has a maximum thickness, along the Z-axis, comprised between 5 nm and 50 nm and preferably lower than 30 nm, for example equal to 10 nm.

The first metal layer 10 includes a surface 10a opposite along the Z-axis with respect to the surface 2b'. The surface 10a of the first metal layer 10 defines the back face 1b of the wafer 1.

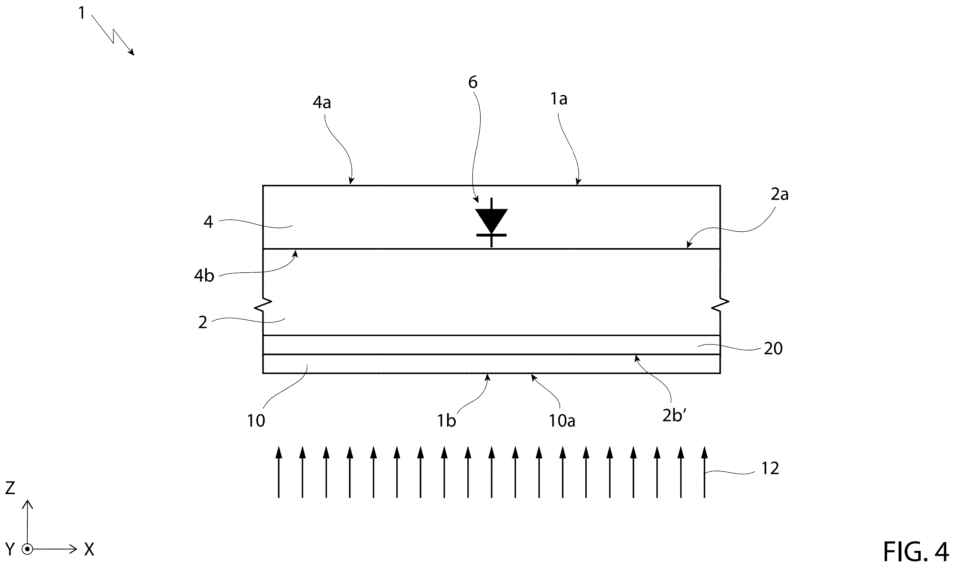

The first metal layer 10 is of a metal adapted to form an ohmic contact with the substrate 2, for example it is of, or includes, titanium (Ti) or nickel (Ni) or molybdenum (Mo) or tungsten (W) or composite materials containing at least one of these metals, for example tungsten carbide (WC) or nickel-vanadium (NiV), or any other metal species that reflects a lower percentage than 50% of the laser radiation, or laser beam, used in the step of Figure 4 and schematically represented by arrows 12.

With reference to Figure 4, a thermal treatment step is performed, in particular by laser (laser annealing) and hereinafter referred to as the laser annealing step, of the first metal layer 10, schematically represented by arrows 12 in Figure 4.

In one embodiment, the laser annealing step is performed through at least one pulsed laser beam.

The laser beam is projected onto the back face 1b of the wafer 1.

The laser beam is generated with the following parameters:
- wavelength comprised between 250 nm and 400 nm, in particular 310 nm;
- pulse duration comprised between 100 and 300 ns, in particular 160 ns; and
- number of pulses comprised between 1 and 5, in particular 2.

By means of this laser beam, an energy density comprised between 1 and 3.5 J/cm², in particular equal to 2.8 J/cm², is supplied to the first metal layer 10.

The laser annealing step is performed in such a way as to heat the first metal layer 10 to a temperature comprised between 1200 °C and 2200 °C, in particular equal to 1800 °C.

The energy density supplied to the first metal layer 10 during the laser annealing step is regulated or adjusted based on the thickness of the first metal layer 10, through the choice of the laser operating parameters.

In particular, the energy density supplied is regulated or adjusted in a manner proportional to the thickness of the first metal layer 10, therefore lower energy density values will correspond to lower thicknesses of the first metal layer 10.

For example, if the first metal layer 10 has a thickness lower than 20 nm, the energy density supplied is lower than or equal to 3.0 J/cm², while if the first metal layer 10 has a thickness greater than 20 nm, the energy density supplied is equal to or greater than 3.0 J/cm².

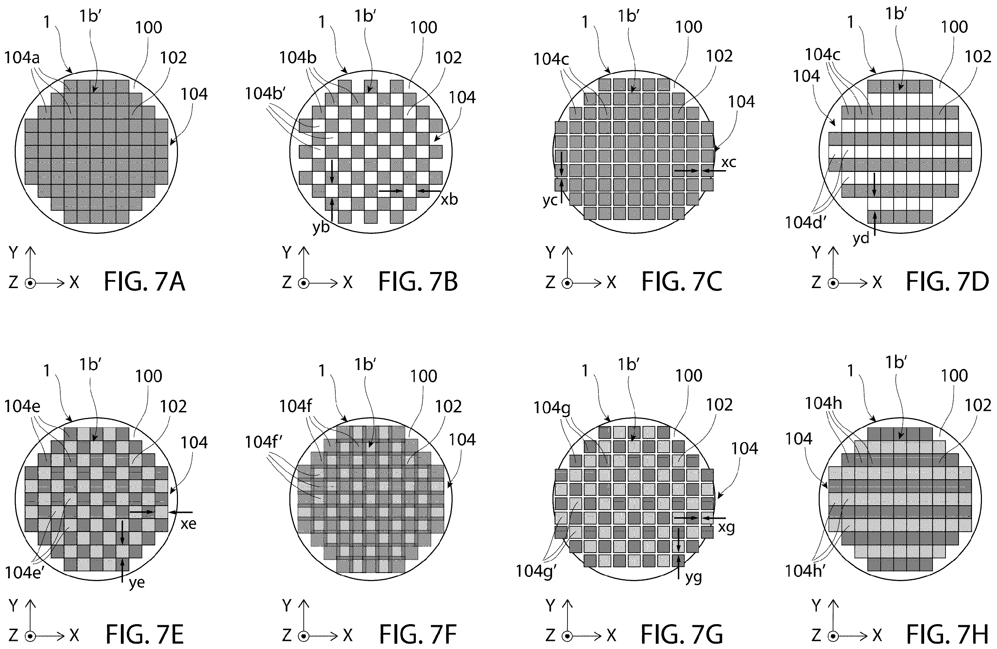

Furthermore, the energy density is suppliable by the laser beam uniformly or non-uniformly on the back face 1b of the wafer 1, for example by further reducing the value of the energy density supplied in selective zones of the back face 1b of the wafer 1, as described below with reference to Figures 7A-7H.

The grinding step, as described, is known to introduce significant structural damage into the near-surface region of the polycrystalline SiC substrate 2. These grinding-induced defects, which include a high density of dislocations and micro-damage to the crystal lattice observable by techniques such as AFM and TEM, are the primary cause of the mechanical stress that leads to wafer deformation. The laser annealing step of the first metal layer 10 is adapted to induce a reorganization of the polycrystalline structure of the Poly-SiC at the interface between the substrate 2 and the first metal layer 10, in particular at the lower surface 2b' of the substrate 2. This results in an interface between the metal silicide layer 20 and the substrate 2 that is substantially free, or completely free, of these specific grinding-induced defects. This reorganization allows to release the mechanical stress accumulated during the grinding process of the wafer 1, eliminating, in whole or in part, the deformation of the wafer 1, therefore compensating or correcting the deformation of the wafer 1. In detail, the first metal layer 10 is adapted to redistribute the energy supplied by the laser during the laser annealing step on the lower surface 2b' of the substrate 2. Furthermore, the lower the thickness of the first metal layer 10, the lower the energy necessary during the laser annealing step to obtain the reorganization of the polycrystalline structure of the Poly-SiC forming the substrate 2. The laser annealing step of the first metal layer 10 is also adapted to form an ohmic contact region 20 which extends in the substrate 2 at the lower surface 2b' of the substrate 2, in direct physical contact with the first metal layer 10. In detail, during the laser annealing step, atoms of the first metal layer 10 diffuse in the substrate 2, and react with silicon and carbon atoms of the Poly-SiC of the substrate 2, forming a silicide layer (hereinafter referred to as "ohmic contact region") 20, for example of titanium silicide (TiSi) or nickel silicide (NiSi) or ternary compounds (TiSiC).

The Applicant has verified that, following the formation of the ohmic contact region 20, the performance of the ohmic contact between the first metal layer 10 and the substrate 2 is improved when the electronic device 6 is operated at high temperature, for example at a temperature higher than 150 °C.

It should be noted that the ranges described above with reference to the thickness of the first metal layer 10 and the laser beam adjustment or regulation parameters, allow to correct the deformations of the wafer 1 and to improve the quality of the ohmic contact between the first metal layer 10 and the substrate 2, without introducing other defect typologies. In particular, the Applicant has verified that, due to the polycrystalline structure of the substrate 2, laser energy densities higher than, for example, 3.5 J/cm² induce the formation of fractures or cracks in the substrate 2 that make the wafer 1 unusable.

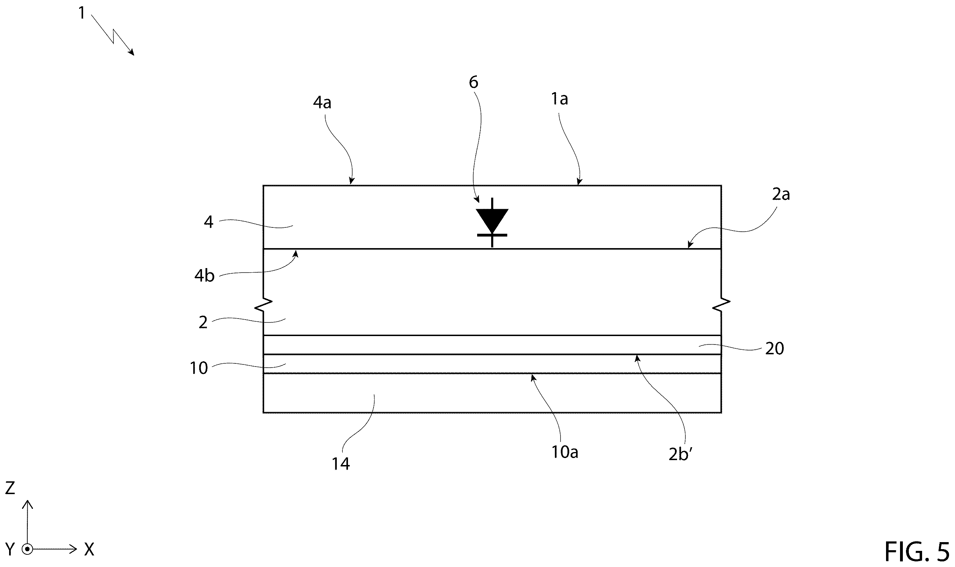

With reference to Figure 5, a deposition step of a second metal layer 14 is then carried out on the surface 10a of the first metal layer 10.

The second metal layer 14 has a maximum thickness along the Z-axis comprised between 0.5 µm and 5 µm, in particular equal to 1 µm. In particular, the thickness of the second metal layer 14 is greater than the thickness of the first metal layer 10.

The second metal layer 14 is for example formed by a layer stack, each layer being of a respective material, for example a layer stack formed by a titanium layer, a nickel layer and a silver layer (Ti/Ni/Ag) or by a titanium layer, a nickel layer and a gold layer (Ti/Ni/Au). Furthermore, the second metal layer 14 is adapted to be coupled with external polarization elements (e.g. by soldering) to provide, in use, a polarization to the substrate 2.

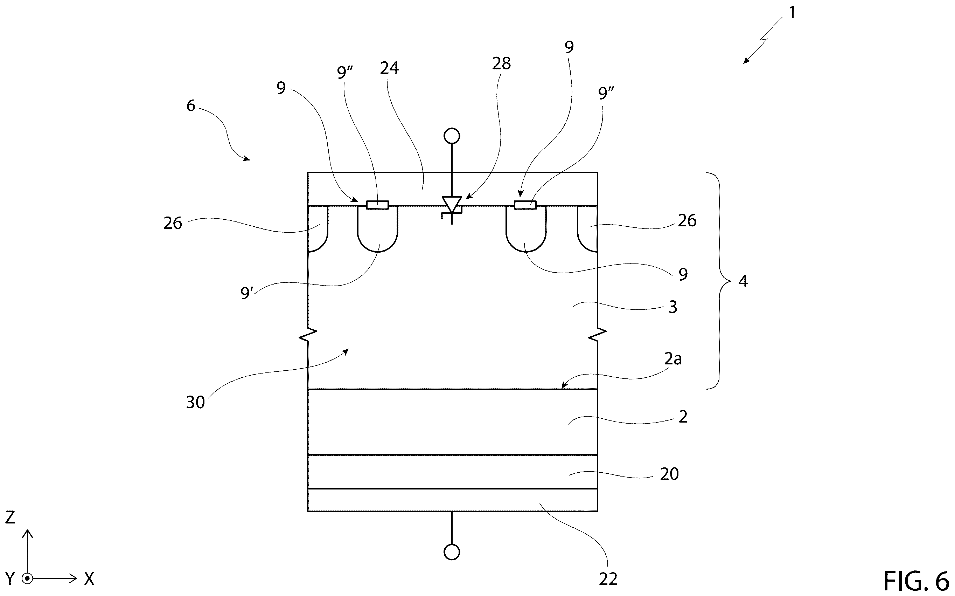

Figure 6 shows in an exemplary manner and without introducing limitations, the electronic device 6 accommodated on the wafer 1. In particular, the electronic device 6 illustrated in Figure 6 is of the merged-PN-Schottky (MPS) type, and is hereinafter referred to as the MPS device 6. Figure 6 is represented in cross-section on the XZ plane.

The MPS device 6 includes: the substrate 2, of N-type Poly-SiC, having a first dopant concentration, provided with the upper surface 2a opposite to the lower surface 2b', and a thickness equal to about 180 µm; a drift layer 3, (epitaxially grown starting from a monocrystalline SiC layer having a thickness along the Z-axis of about 500 nm, bonded to the upper surface 2a of substrate 2, not shown) of N-type SiC, having a second dopant concentration lower than the first dopant concentration, which extends on the upper surface 2a of the substrate 2, and a thickness comprised between 5 and 10 µm; the ohmic contact region 20 (e.g. of titanium silicide or nickel silicide), which extends in the substrate 2 at the lower surface 2b' of the substrate 2; a cathode metallization 22, which extends on the ohmic contact region 20. The cathode metallization 22 includes, although not illustrated in Figure 6, the first metal layer 10 and the second metal layer 14.

The MPS device 6 further includes an anode metallization 24 which extends on an upper surface 3a of the drift layer 3; multiple Junction-Barrier (JB) elements 9 in the drift layer 3, facing the upper surface 3a of the drift layer 3 and each including a respective implanted region 9' of the P-type and an ohmic contact 9" of metal material; and an edge termination region, or protection ring, 26 (optional), in particular a P-type implanted region, which completely surrounds the junction-barrier (JB) elements 9.

Schottky diodes 28 are formed at the interface between the drift layer 3 and the anode metallization 24. In particular, Schottky (semiconductor-metal) junctions are formed by portions of the drift layer 3 in direct electrical contact with respective portions of the anode metallization 24.

The region of the MPS device 6 which includes the JB elements 9 and the Schottky diodes 28 (i.e., the region contained within the protection ring 26) is an active area 30 of the MPS device 6.

The drift layer 3, the anode metallization 24, the junction barrier (JB) elements 9 and the protection ring 26 form the layer stack 4.

Figures 7A-7H illustrate respective patterns A-H according to which the energy density is supplied by the laser to the back face 1b during the laser annealing step, in the triaxial system of axes X,Y,Z and in plan view on the XY plane.

With reference to any of Figures 7A-7H, the back face 1b includes an edge region 100 and a central region 102. In view on the XY plane, the central region 102 comprises and surrounds the electronic devices 6 (accommodated at the front face 1a of the wafer 1). The edge region 100 extends on the XY plane surrounding, at least in part, the central region 102. In other words, the central region 102 is the region of the wafer 1 usable for manufacturing electronic devices and, subsequently, used and usable for dicing the wafer 1.

In particular, the patterns A-H envisage that the edge region 100 is not irradiated by the laser beam. The patterns A-H also envisage that the central region 102 is divided into a grid or matrix 104 formed by a plurality of cells which extend on the XY plane, for example each cell having a square shape.

With reference to Figures 7A-7D, respective patterns A-D are now described, which envisage to irradiate, with a first laser beam, selective portions of the region 102, thus supplying a first energy density selectively to the sole irradiated portions.

The first laser beam is generated with a first set of parameters chosen such that the parameters fall within the respective ranges described with reference to Figure 4.

With reference to Figure 7A, the grid 104 contains a plurality of cells 104a, here exemplarily of square shape, wherein each cell 104a extends in contact with its nearest neighbours cells 104a along the X-axis and along the Y-axis. According to pattern A, each cell 104a receives the first energy density by means of the first laser beam. In other words, according to pattern A the entire central region 102 receives the first energy density by means of the first laser beam.

According to pattern B illustrated in Figure 7B, the grid 104 contains a plurality of cells 104b exemplarily of square shape which receive the first energy density by means of the first laser beam, and a plurality of square cells 104b' which do not receive the first energy density. The cells 104b and 104b' extend respectively alternated to each other along the X-axis and along the Y-axis, such that each cell 104b is in contact with the respective nearest neighbours cells 104b' along the X-axis and is in contact with the respective nearest neighbours cells 104b' along the Y-axis.

In other words, according to pattern B, each cell 104b extends at a distance from its nearest neighbours cells 104b along the X-axis, at a distance from its nearest neighbours cells 104b along the Y-axis, and in contact with its nearest neighbours cells 104b along directions diagonal with respect to the axes X and Y. In particular, a distance xb along the X-axis between nearest neighbours cells 104b is comprised between 1 mm and 30 mm; a distance yb along the Y-axis between nearest neighbours cells 104b is comprised between 1 mm and 30 mm. The distances xb and yb are, for example, equal to respective extensions of the cells 104b' along the X-axis and along the Y-axis, respectively.

According to pattern C illustrated in Figure 7C, the grid 104 contains a plurality of cells 104c, exemplarily of square shape. Each cell 104c extends at a distance xc from its nearest neighbours cells 104c along the X-axis. The distance xc is comprised for example between 1 mm and 30 mm. Each cell 104c extends at a distance yc from its nearest neighbours cells 104c along the Y-axis. The distance yc is comprised between 1 mm and 30 mm. According to pattern C, each cell 104c receives the first energy density by means of the first laser beam.

According to pattern D illustrated in Figure 7D, the grid 104 contains a plurality of cells 104d exemplarily of square shape. Each cell 104d extends in contact with its nearest neighbours cells 104d along the X-axis. Each cell 104d extends at a distance yd from its nearest neighbours cells 104d along the Y-axis. The distance yd is comprised for example between 1 mm and 30 mm and is equal to, for example, one extension along the Y-axis of a cell 104d. According to pattern D, each cell 104d receives the first energy density by means of the first laser beam.

In other words, according to pattern D illustrated in Figure 7D, the grid 104 contains a plurality of cells 104d, exemplarily of square shape, which receive the first energy density by means of the first laser beam, and a plurality of cells 104d', exemplarily of square shape, which do not receive the first energy density. The cells 104d and 104d' extend respectively alternated to each other along the Y-axis. The cells 104d extend along the X-axis adjacent to respective nearest neighbours cells 104d. The cells 104d' extend along the X-axis adjacent to respective nearest neighbours cells 104d'. In other words, in grid 104 of Figure 7D, the cells 104d extend to form a plurality of rows parallel to the X-axis; similarly, the cells 104d' also extend to form a plurality of rows parallel to the X-axis. The rows formed by the cells 104d are alternated, along the Y-axis, to the rows formed by the cells 104d'.

With reference to Figures 7E-7H, respective patterns EH are now described which envisage to provide a first set of selective portions of the central region 102 with the first energy density and a second set of selective portions of the central region 102 with a second energy density, respectively by means of the first laser beam and by means of a second laser beam generated with a second set of parameters, wherein the first and second sets of parameters are chosen such that the parameters fall within the respective ranges described with reference to Figure 4. In particular, the values of the parameters of the first and second sets are, at least in part, different from each other.

With reference to Figure 7E, the grid 104 contains a plurality of cells 104e, exemplarily of square shape, which receive the first energy density supplied by the first laser beam, and a plurality of cells 104e', exemplarily of square shape, which receive the second energy density supplied by the second laser beam. The cells 104e and 104e' extend respectively alternated to each other along the X-axis and along the Y-axis, such that each cell 104e is in contact with the respective nearest neighbours cells 104e' along the X-axis and along the Y-axis.

In other words, according to pattern E, each cell 104e extends at a distance from its nearest neighbours cells 104e along the X-axis, at a distance from its nearest neighbours cells 104e along the Y-axis, and in contact with its nearest neighbours cells 104e along directions diagonal with respect to the axes X and Y. In particular, a distance xe along the X-axis between nearest neighbours cells 104e is comprised between 1 mm and 30 mm; a distance ye along the Y-axis between nearest neighbours cells 104e is comprised between 1 mm and 30 mm. The distances xe and ye are, for example, equal to respective extensions of the cells 104e' along the X-axis and along the Y-axis, respectively.

According to pattern F illustrated in Figure 7F, the grid 104 contains a plurality of cells 104f, exemplarily of square shape, which receive the first energy density supplied by the first laser beam, and a plurality of cells 104f', exemplarily of square shape, which receive the second energy density supplied by the second laser beam. The cells 104f and 104f' extend respectively alternated to each other along the X-axis and along the Y-axis, and such that each cell 104f extends superimposing in part on the respective first nearest neighbours cells 104f' along the X-axis and/or along the Y-axis.

According to pattern G illustrated in Figure 7G, the grid 104 contains a plurality of cells 104g, exemplarily square, which receive the first energy density supplied by the first laser beam, and a plurality of cells 104g', exemplarily square, which receive the second energy density supplied by the second laser beam. Each cell 104g extends at a distance xg from its nearest neighbours cells 104g' along the X-axis. The distance xg is comprised, for example, between 1 mm and 30 mm. Each cell 104g extends at a distance yg from its nearest neighbours cells 104g' along the Y-axis. The distance yg is comprised, for example, between 1 mm and 30 mm.

According to pattern H illustrated in Figure 7H, the grid 104 contains a plurality of cells 104h, exemplarily square, which receive the first energy density supplied by the first laser beam, and a plurality of cells 104h', exemplarily square, which receive the second energy density supplied by the second laser beam. The cells 104h and 104h' extend respectively alternated to each other along the Y-axis, such that each cell 104h is adjacent to the respective nearest neighbours cells 104h along the X-axis, and each cell 104h is adjacent to the respective nearest neighbours cells 104h' along the Y-axis. In other words, in the grid 104 of Figure 7H, the cells 104h extend to form a plurality of rows parallel to the X-axis; similarly, the cells 104h' also extend to form a plurality of rows parallel to the X-axis. The rows formed by the cells 104h are alternated, along the Y-axis, to the rows formed by the cells 104h'.

Finally, it is clear that modifications and variations may be made to what has been described and illustrated herein without thereby departing from the scope of the present invention, as defined in the attached claims.

For example, although the device 6 has been described with reference to an MPS device, the present invention may equally be applied without limitations to other typologies of electronic devices, such as for example MOSFETs or IGBTs.

Furthermore, although patterns A-H have been described with reference to a grid 104 which includes a plurality of square cells, other grids are possible, which include for example rectangular or polygonal cells in general.

Furthermore, the laser annealing step may be carried out by a single pass of each laser beam on the back face 1b of the wafer 1, or by means of more than one pass of each laser beam.

In the light of what has been previously exposed, the advantages that the present invention affords are evident.

In particular, the proposed solution allows to mitigate or completely eliminate the deformations of the wafer 1 resulting from the grinding step. In other words, the proposed solution allows to compensate or correct the deformation of the wafer 1. The implementation of such a manufacturing method may lead to a drastic increase in the yield of the manufacturing processes, to a decrease in the breakdowns of the Poly-SiC wafers, and to an increase in the quality of the devices.

In particular, the local heating due to the laser annealing step of the metal-Poly-SiC interface on the new back surface 1b of the wafer 1, facilitates the reordering or rearrangement of the polycrystalline structure of the Poly-SiC, with consequent reduction in the stresses and deformation of the wafer 1. Furthermore, such local heating due to the laser annealing step improves the properties of the ohmic contact formed between the first metal layer 10 and the substrate 2. This process contributes to restoring the structural integrity of the wafer 1, improving its suitability for the subsequent manufacturing steps.

Furthermore, by distributing the energy density supplied by the laser beam in a non-uniform manner on the back face 1b of the wafer 1 (in particular on the first metal layer 10), the value of energy density supplied in selective zones of the back face 1b of the wafer 1 may be further reduced, further reducing the risk of forming cracks in the substrate 2.

The method according to the present invention, as defined in claim 1, provides a synergistic solution to the problem of mechanical stress and a high density of structural defects caused by mechanical grinding of polycrystalline silicon carbide substrates. By introducing a grinding step before a specifically controlled heating step, the invention directly addresses the cause of the deformation. The application of a first energy density within the range of 1 J/cm² to 3.5 J/cm² provides sufficient thermal energy to induce a reorganization of the polycrystalline structure at the grinded interface, thereby releasing the accumulated stress. Furthermore, the regulation of this energy density, such that lower energy values correspond to lower thicknesses of the metal layer, ensures that this structural reorganization is performed with high precision across the wafer. This prevents localized overheating that could cause new damage, such as cracks, while ensuring all regions receive sufficient energy for defect healing. The use of a matrix-type pattern allows this targeted thermal treatment to be applied selectively. This combination of features provides a robust method that mitigates or completely eliminates the wafer deformation resulting from the grinding process, leading to a drastic increase in manufacturing yield and improved final device quality.

## Claims

1. A method of manufacturing an electronic device, comprising the steps of:
- providing a substrate (2) of polycrystalline silicon carbide, SiC, having a first surface (2a) and a second surface (2b') opposite to the first surface (2a) along a first direction (Z);- depositing, on the second surface (2b'), a metal layer (10) having a third surface (10a) opposite to the second surface (2b') along the first direction (Z);
- heating, by means of a first laser beam, a first set of portions of the metal layer (10) at the third surface (10a), said first set of portions being chosen from among a plurality of portions (104) of the metal layer (10) which extend, at the third surface (10a),
**characterized by** further comprising, before the step of depositing the metal layer (10), a step of grinding the substrate (2) to reduce its thickness,
wherein the heating step is performed on the grinded substrate according to a matrix-type pattern having rows along a second direction (X) orthogonal to the first direction (Z) and columns along a third direction (Y) transverse to the second direction (X) and orthogonal to the first direction (Z),
and wherein the heating step comprises supplying a first energy density between 1 J/cm² and 3.5 J/cm², the first energy density being regulated in a manner proportional to a thickness of the metal layer (10), in particular such that lower energy density values correspond to lower thicknesses of the metal layer (10).

2. The method according to claim 1, wherein regulating the first energy density comprises:
- supplying the first energy density at a value lower than or equal to 3.0 J/cm² for portions of the metal layer (10) having a thickness lower than 20 nm; and
- supplying the first energy density at a value equal to or greater than 3.0 J/cm² for portions of the metal layer (10) having a thickness greater than 20 nm.

3. The method according to claim 1 or claim 2, wherein the first laser beam is generated with a first set of parameters comprising:
- a first wavelength comprised between 250 nm and 400 nm;
- a first pulse duration comprised between 100 ns and 300 ns; and
- a first number of pulses comprised between 1 and 5.

4. The method according to anyone of the preceding claims, wherein the plurality of portions (104) comprises first portions (104b; 104d; 104e; 104f; 104g; 104h) and second portions (104b'; 104d'; 104e'; 104f'; 104g'; 104h') which extend alternated to each other along the third direction (Y), and wherein the first set of portions comprises the first portions (104b; 104d; 104e; 104f; 104g; 104h).

5. The method according to claim 4, wherein the first portions (104b; 104e; 104f; 104g) and the second portions (104b'; 104d'; 104e'; 104f'; 104g') extend alternated to each other along the second direction (X).

6. The method according to anyone of the preceding claims, further comprising heating, by means of a second laser beam, a second set of portions among the plurality of portions (104), the second set of portions being different from the first set of portions.

7. The method according to claim 6 when dependent on claim 4 or 5, wherein the second set of portions comprises the second portions (104e'; 104f'; 104g'; 104h').

8. The method according to claim 1, wherein the first set of portions coincides with said plurality of portions (104).

9. The method according to anyone of the preceding claims, wherein the portions of the plurality of portions (104) extend adjacent to respective nearest neighbours portions along the second direction (X) and the third direction (Y);
alternatively, wherein the portions of the plurality of portions (104) extend at a distance from respective nearest neighbours portions along the second direction (X) and the third direction (Y) alternatively,
wherein the portions of the plurality of portions (104) extend in part superimposed on respective nearest neighbours portions along the second direction (X) and the third direction (Y).

10. The method according to claim 6 or claim 7 when dependent on claim 3, wherein heating by means of the second laser beam the second set of portions comprises generating the second laser beam with a second set of parameters comprising:
- a second wavelength comprised between 250 nm and 400 nm;
- a second pulse duration comprised between 100 and 300 ns;
- a second number of pulses comprised between 1 and 5,
wherein at least one parameter among the second wavelength, the second pulse duration, and the second number of pulses is different from a respective parameter among the first wavelength, the first pulse duration, and the first number of pulses.

11. The method according to claim 6 or claim 7, wherein heating by means of the second laser beam the second set of portions comprises supplying, to the second set of portions by means of the second laser beam, a second energy density comprised between 1 and 3.5 J/cm² and different from the first energy density.

12. The method according to anyone of the preceding claims, wherein the first metal layer 10 has a thickness equal to, or lower than, 50 nm, in particular equal to, or lower than, 10 nm.

13. The method according to anyone of the preceding claims, wherein the substrate (2) has a maximum thickness, between the first surface (2a) and the second surface (2b') along the first direction (Z), equal to or lower than 200 µm.

14. An electronic device, comprising:
- a substrate (2) of polycrystalline silicon carbide, SiC, having a first surface (2a) and a second surface (2b') opposite to the first surface (2a);
- a first metal layer (10), extending on, and in direct physical contact with, the second surface (2b') of the substrate (2);
- a metal silicide layer (20) extending at the second surface (2b') of the substrate (2), in direct physical contact with the first metal layer (10);
wherein the first metal layer (10) has a first thickness equal to, or lower than, 50 nm, in particular equal to, or lower than, 10 nm; and wherein the substrate (2) has a maximum thickness, between the first surface (2a) and the second surface (2b'), equal to or lower than 200 µm, **characterized in that** an interface between the metal silicide layer (20) and the substrate (2) is a reorganized polycrystalline structure that is substantially free of grinding-induced defects.

15. The electronic device according to claim 14, further comprising a second metal layer (14) on the first metal layer (10), the second metal layer (14) having a thickness greater than the first metal layer (10).
